(19) Europäisches Patentamt
European Patent Office
Office européen des brevets

(11) EP 2 298 551 B1

(12) **EUROPEAN PATENT SPECIFICATION**

(45) Date of publication and mention of the grant of the patent:
**17.01.2018 Bulletin 2018/03**

(51) Int Cl.:
***H01L 51/52*** *(2006.01)* ***C08J 7/04*** *(2006.01)*

(21) Application number: **10174841.6**

(22) Date of filing: **01.09.2010**

(54) **Gas barrier film and device**

Gassperrfilm und Vorrichtung

Film barrière à gaz et dispositif

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **01.09.2009 JP 2009201849**

(43) Date of publication of application:
**23.03.2011 Bulletin 2011/12**

(73) Proprietor: **Fujifilm Corporation**
**Minato-ku**
**Tokyo 106-8620 (JP)**

(72) Inventor: **Murakami, Tomoo**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:

| | |
|---|---|
| **EP-A1- 1 842 873** | **EP-A2- 2 033 988** |
| **US-A1- 2004 160 178** | **US-A1- 2007 224 413** |
| **US-A1- 2008 220 198** | **US-B1- 6 413 645** |

- **LEWIS ET AL: "Material challenge for flexible organic devices", MATERIALS TODAY, ELSEVIER SCIENCE, KIDLINGTON, GB, vol. 9, no. 4, 1 April 2006 (2006-04-01), pages 38-45, XP025174821, ISSN: 1369-7021, DOI: DOI:10.1016/S1369-7021(06)71446-8 [retrieved on 2006-04-01]**
- **LEWIS J S ET AL: "Thin-Film Permeation-Barrier Technology for Flexible Organic Light-Emitting Devices", IEEE JOURNAL OF SELECTED TOPICS IN QUANTUM ELECTRONICS, IEEE SERVICE CENTER, PISCATAWAY, NJ, US, vol. 10, no. 1, 1 January 2004 (2004-01-01), pages 45-57, XP011111058, ISSN: 1077-260X, DOI: DOI:10.1109/JSTQE.2004.824072**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 298 551 B1

## Description

### FIELD OF THE INVENTION

The invention relates to a gas barrier film used for a substrate of an organic EL device and the like, and a device using the gas barrier film.

### RELATED ART OF THE INVENTION

A gas barrier film, which is a film shutting oxygen and moisture vapor, is desired to have a usable area as large as possible when such a gas barrier film is used for shutting a substrate of a device such as an organic EL device. More specifically, when a gas barrier film is cut to a desired size in order to form an organic EL panel, its "discarded dimension", that is width by which the gas barrier film is cut at its side or its surround, is desired to shorten. The discarded dimension is preferably shorter. Specifically, it is practically requested to be 5 mm or less. In process of cutting such a gas barrier film, microflexion of the gas barrier film occurs. Therefore, in order to cut properly such a gas barrier film by shorter discarded dimension and without damaging thereof, the gas barrier film is required to have high flexibility.

JP-A-2006-68967 discloses a barrier laminate comprising an organic layer, an inorganic thin film and a coating layer, wherein the hardness of the coating layer measured by the nanoindentation at the atmosphere at 23°C is 0.1 to 0.5 GPa, and which is obtained by laminating an unstretched polypropylene film having a thickness of 60 μm on the surface of the coating layer. However, the object of JP-A-2006-68967 is to maintain oxygen barrier property after the gas barrier film is subjected to heat moisture treatment at high temperature, so that the outermost layer is indispensably polypropylene. Polypropylene becomes a disincentive in the case of using an organic EL device.

JP-A-2007-290369 discloses a gas barrier film excellent in flexibility, which comprises an organic layer obtained by curing a polymerizable composition comprising an acrylate monomer having a phosphoester group. The gas barrier film, however, doesn't have flexibility enough to solve the above problem.

### SUMMARY OF THE INVENTION

As mentioned above, flexibility in a gas barrier film is important factor, which had not been completely solved. For example, when the number of layers of such a gas barrier film is increased so as to enhance the gas barrier property thereof, the flexibility thereof tends to decrease. The object of the invention is to provide a gas barrier film excellent in flexibility in addition to gas barrier property.

Under such situation, the inventor has found that, in a gas barrier film comprising an organic layer and an inorganic layer on a substrate, the flexibility thereof in addition to the barrier property thereof is attained by providing a thick organic layer as the outermost layer to thereby reduce bending stress which may transmit to an inorganic layer, providing an organic layer as an intermediate layer, and trying to variously change a thickness ratio between the outermost organic layer and the intermediate organic layer. Thereby, the inventor has completed the invention.

Specifically the above-mentioned problems can be solved by the invention as defined by the appended claims. The invention makes it possible to provide a gas barrier film excellent in both of barrier property and flexibility.

### BRIEF DESCRIPTION OF THE DRAWING

Fig. 1 is a diagrammatic illustration showing one example of an embodiment of the gas barrier film of the invention. Fig. 2 is a diagrammatic illustration showing another example of an embodiment of the gas barrier film of the invention.

### DESCRIPTION OF SPECIFIC EMBODIMENTS

The contents of the invention are described in detail hereinunder. In this description, the numerical range expressed by the wording "a number to another number" means the range that falls between the former number indicating the lowermost limit of the range and the latter number indicating the uppermost limit thereof. In this description, "organic EL device" means organic electro light emitting device. In addition, "(meth)acrylate" means acrylate and methacrylate in the present specification.

The gas barrier film of the invention comprises a substrate, a first organic layer, an inorganic layer, and an outermost organic layer in that order, wherein the outermost organic layer has a thickness of 0.3 μm or more, and which satisfies the following formula;

$$a/b \geqq 2$$

wherein a represents a thickness of the outermost organic layer, b represents a thickness of the first organic layer. Such a laminate structure can improve the flexibility and reduce discarded dimension in cutting the gas barrier film.

Fig. 1 shows a diagrammatic illustration showing one example of an embodiment of the gas barrier film of the invention, wherein 1 stands for a substrate film, 2 stands for a first organic layer, 3 stands for an inorganic layer and 4 stands for an outermost organic layer. While the first organic layer, the inorganic layer and the outermost organic layer are successively laminated in the embodiment, a layer other than those layers such as a functional layer may be laminated therebetween without diverting the scope of the invention. The preferable embodiment is that the first organic layer, the inorganic layer and the outermost layer are successively laminated.

In the invention, the structure satisfies the following formula;

$$a/b \geqq 2$$

wherein a represents a thickness of the outermost organic layer, b represents a thickness of the first organic layer, and more preferably $a/b \geqq 2.5$, further more preferably $a/b \geqq 3$.

In the invention, the thickness of the outermost layer is 0.3 $\mu$m or more, preferably 0.5 $\mu$m or more, more preferably 1.0 $\mu$m or more. The upper limit is 10 $\mu$m or less.

As mentioned above, the flexibility can be enhanced by increasing the thickness of the outermost organic layer and by setting the thickness ratio between the outermost organic layer and the first organic layer to such a desired range. The invention is adoptable regardless of kinds of material compositing the organic layer, so that it can be widely used. In addition, since the outermost organic layer has a thick thickness, the gas barrier film of the invention is hardly damaged. In particular, the invention is remarkably advantageous from the viewpoints that organic-inorganic laminate type gas barrier film is easily damaged.

In the invention, a layer may be provided on the surface of the outermost organic layer without diverting the scope of the invention. Examples of such a layer include an adhesive layer, a layer required in manufacturing a device such as a light-emitting layer in an organic EL device, and another functional layer.

Fig. 2 shows a diagrammatic illustration showing another example of an embodiment of the gas barrier film of the invention, wherein, on the substrate film 1, a second organic layer 5, an inorganic layer 3, a first organic layer 2, an inorganic layer 3, and an outermost organic layer 4 are laminated. The embodiment is characterized in comprising two inorganic layers. The lamination of two inorganic layers tends to enhance the barrier property. In the embodiment, while the second organic layer 5 is provided, at least one organic layer and at least one inorganic layer may be further laminated. In the gas barrier film of the invention, such an organic layer and such an inorganic layer are generally laminated alternatively.

In the description, the above second organic layer stands for an organic layer other than the outermost organic layer. In the case of laminating three organic layers as shown in Fig. 2, the third organic layer from the outermost organic layer stands for the second organic layer. Similarly, the third organic layer or subsequent layers stand for an organic layer other than the outermost organic layer, which is the fourth or subsequent organic layer from the outermost organic layer.

(Outermost Organic Layer)

The outermost organic layer in the invention is preferably an organic layer comprising an organic polymer as a main ingredient. Herein, the main ingredient means that the highest in ingredient composing the outermost organic layer is an organic polymer, and generally 80% by weight or more in ingredient composing the outermost organic layer is an organic polymer.

Examples of the organic polymer include a thermoplastic resin such as polyester, acrylic resin, methacrylic resin, methacrylic acid/maleic acid copolymer, polystyrene, transparent fluororesin, polyimide, fluoropolyimide, polyamide, polyamidimide, polyetherimide, cellulose acylate, polyurethane, polyether-ether ketone, polycarbonate, alicyclic polyolefin, polyarylate, polyether sulfone, polysulfone, fluorene ring-modified polycarbonate, alicyclic-modified polycarbonate, fluorene ring-modified polyester and acryloyl compound, and an organosilicon polymer such as polysiloxane.

In the invention, the outermost organic layer is preferably a layer obtainable by curing a polymerizable composition comprising polymerizable monomers.

(Polymerizable Compound)

The polymerizable compound for use in the invention is preferably a radical polymerizable compound and/or a cationic polymerizable compound having an ether group as a functional group, more preferably a compound having an ethylenic unsaturated bond at the terminal or in the side chain thereof, and/or a compound having epoxy or oxetane at the terminal or in the side chain thereof. Of those, preferred is a compound having an ethylenic unsaturated bond at the terminal or in the side chain thereof. Examples of the compound having an ethylenic unsaturated bond at a terminal or in a side chain thereof include (meth)acrylate compounds, acrylamide compounds, styrene compound, maleic anhydride, etc, and preferably (meth) acrylate compounds and/or styrene compound, more preferably (meth)acrylate compounds.

As (meth) acrylate compounds, preferred are (meth) acrylates, urethane-(meth)acrylates, polyester-(meth)acrylates, epoxy(meth)acrylates, etc.

As styrene compounds, preferred are styrene, α-methylstyrene, 4-methylstyrene, divinylbenzene, 4-hydroxystyrene, 4-carboxystyrene, etc.

Specific examples of (meth) acrylate compounds are mentioned below, to which, however, the invention should not be limited.

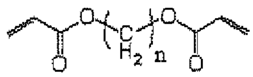 n=4,6,9,10,12,14,16 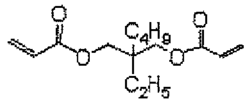

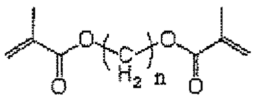 n=4,6,9,10,12,14,16 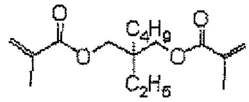

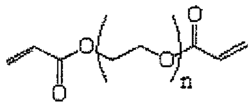 n=2,3,4,5 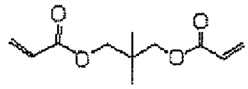

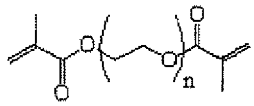 n=2,3,4,5 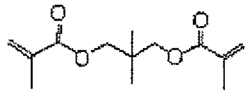

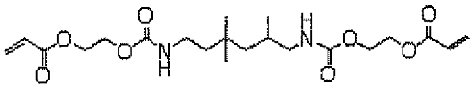 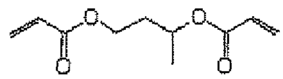

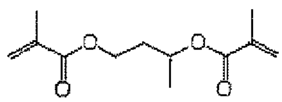

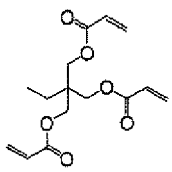

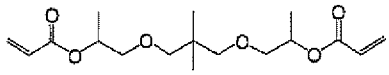

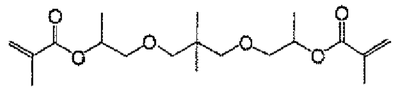

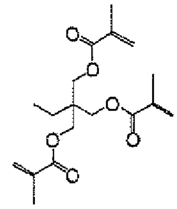

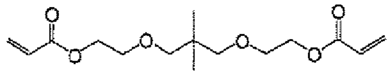

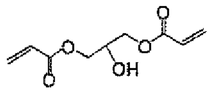

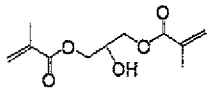

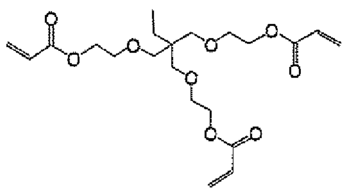

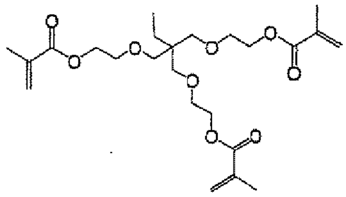

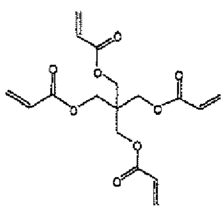

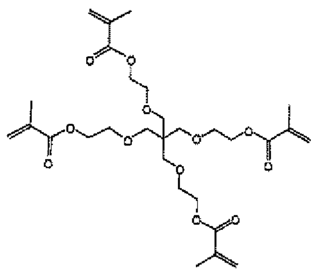

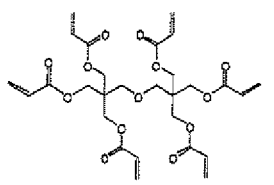

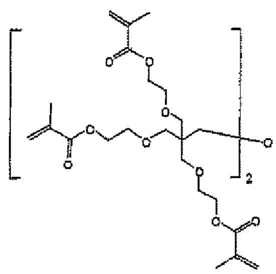

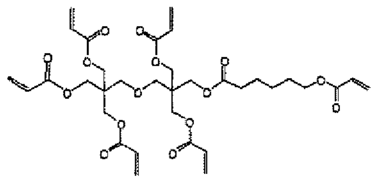

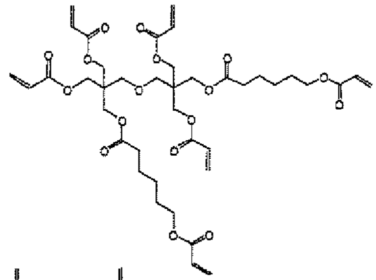

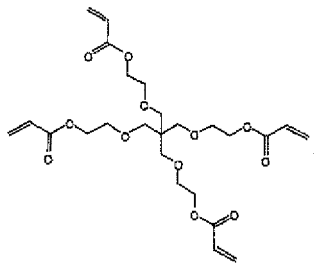

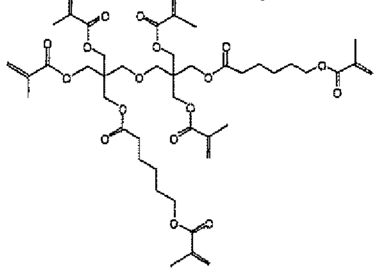

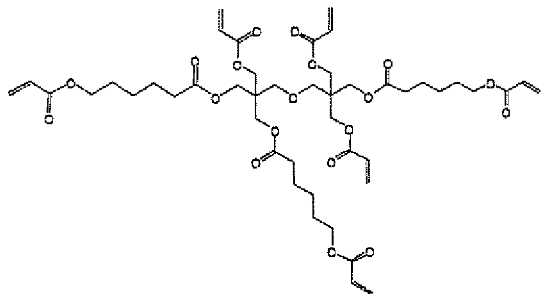

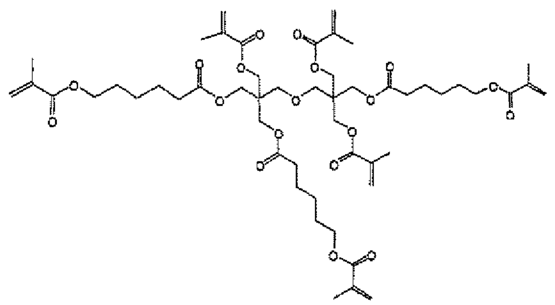

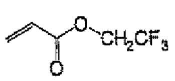

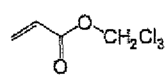

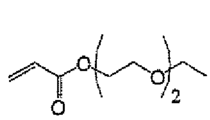

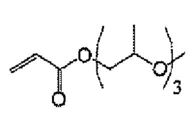

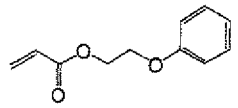

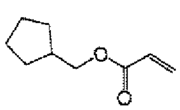

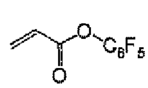

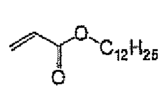

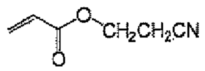 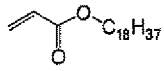 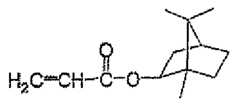

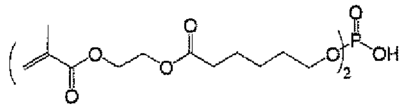 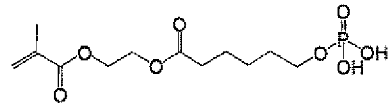

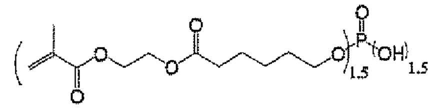 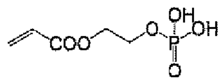

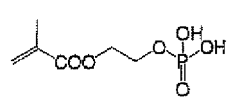 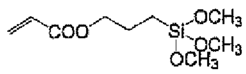 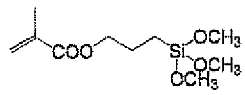

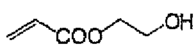 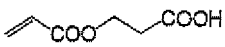 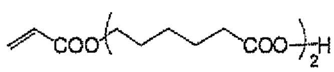

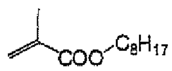 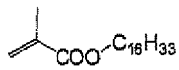 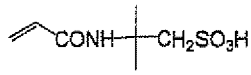

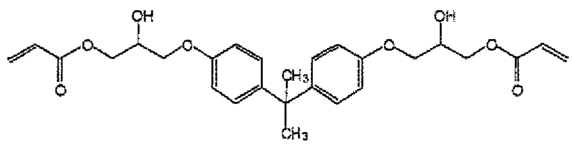

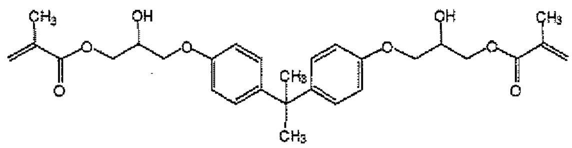

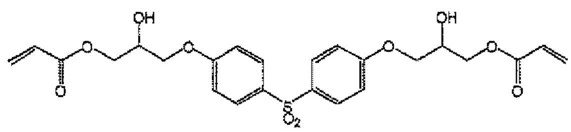

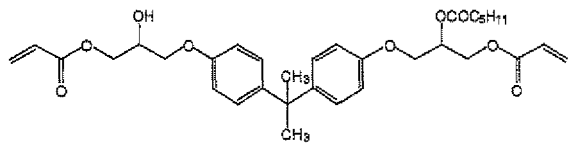

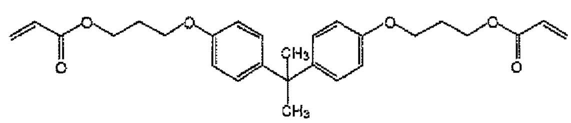

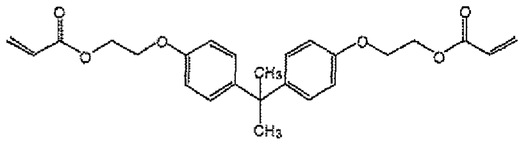

((Meth)acrylate having a phosphoester group)

The polymerizable composition of the invention preferably comprises a (meth)acrylate having a phosphoester group. The (meth) acrylate having a phosphoester group is preferably a compound represented by the formula (P). The inclusion of the (meth) acrylate compound having a phosphorester group improves the adhesion to the inorganic layer.

formula (P)

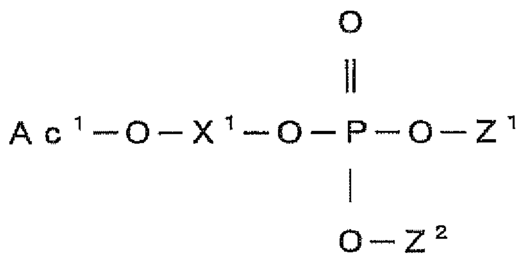

wherein $Z^1$ represents $Ac^2$-O-$X^2$-, a substituent group not having a polymerizable group, or a hydrogen atom, $Z^2$ represents $Ac^3$-O-$X^3$-, a substituent group not having a polymerizable group, or a hydrogen atom, $Ac^1$, $Ac^2$ and $Ac^3$ each represent an acryloyl group or a methacryloyl group, and $X^1$, $X^2$ and $X^3$ each an alkylene group, an alkyleneoxy group, an alkyleneoxycarbonyl group, or an alkylenecarbonyloxy group, or a combination thereof.

The compound represented by the formula (P) is preferably a monofunctional monomer represented by the formula (P-1), a bifunctional monomer represented by the formula (P-2) and a trifunctional monomer represented by the formula (P-3).

formula (P-1)

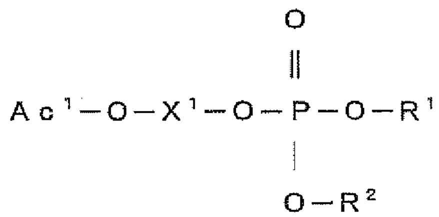

formula (P-2)

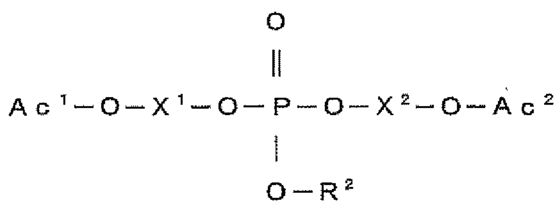

formula (P-3)

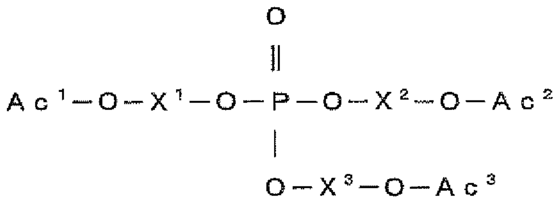

The definitions of $Ac^1$, $Ac^2$, $Ac^3$, $X^1$, $X^2$ and $X^3$ are the same as those in the formula (P). In the formula (P-1) and formula (P-2), $R^1$ represents a substituent not having a polymerizable group, or a hydrogen atom, and $R^2$ represents a substituent group not having a polymerizable group, or a hydrogen atom.

In the formula (P), (P-1) to (P-3), the carbon numbers of $X^1$, $X^2$ and $X^3$ are preferably 1 to 12, more preferably 1 to 6, still more preferably 1 to 4. Examples of the alkylene group which $X^1$, $X^2$ and $X^3$ may have, and examples of the alkylene portion of the alkyleneoxy group, the alkyleneoxycarbonyl group and the alkylenecarbonyloxy group which $X^1$, $X^2$ and $X^3$ may have include a methylene group, an ethylene group, a propylene group, a butylene group, a pentylene group, and a hexylene group. The alkylene group may be a linear or branched alkylene group, preferably a linear alkylene group. $X^1$, $X^2$ and $X^3$ are preferably an alkylene group.

In the formula (P), (P-1) to (P-3), examples of the substituent group not having a polymerizable group include an alkyl group, an alkoxy group, an aryl group and an aryloxy group, and a combination thereof. Preferred is an alkyl group and an alkoxy group, and more preferred is an alkoxy group.

The carbon number of the alkyl group is preferably 1 to 12, more preferably 1 to 9, still more preferably 1 to 6. Examples of the alkyl group include a methyl group, an ethyl group, a propyl group, a butyl group, a pentyl group and a hexyl group. The alkyl group may be a linear, branched, or cyclic group, and preferably a linear alkyl group. The alkyl group may be substituted with an alkoxy group, an aryl group, an aryloxy group, and the like.

The carbon number of the aryl group is preferably 6 to 14, more preferably 6 to 10. Examples of the aryl group include a phenyl group, a 1-naphthyl group, and a 2-naphtyl group. The aryl group may be substituted with an alkyl group, an alkoxy group, an aryloxy group, and the like.

As the alkyl portion of the alkoxy group and the aryl portion of the aryloxy group, the above explanation for the alkyl group and the aryl group may be referred to.

In the invention, the monomer represented by the formula (P) may be used singly or as combined. When the compounds are used as combined, may be used a combination comprising two or more kinds of a monofunctional compound represented by the formula (P-1), a bifunctional compound represented by the formula (P-2) and a trifunctional compound represented by the formula (P-3).

In the invention, as the above polymerizable monomers having a phosphate group, may be used commercially available compounds such as KAYAMER series manufactured by NIPPON KAYAKU CO., LTD, and Phosmer series manufactured by Uni chemical, and a compound newly synthesized.

Specific examples of the (meth)acrylate having a phosphate group, which is preferably used in the invention, mentioned below, to which, however, the invention should not be limited.

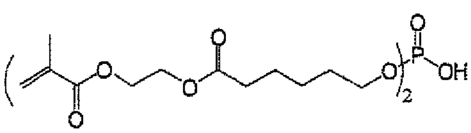

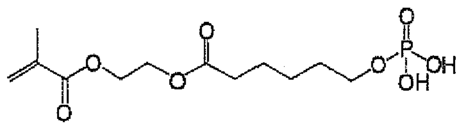

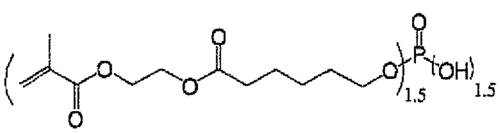

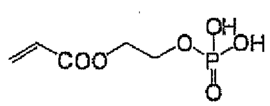

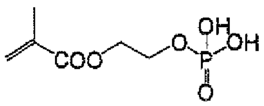

The amount of the (meth) acrylate having a phosphate group in the polymerizable composition is preferably 0.01 to 50 % by weight, more preferably 0.1 to 30 % by weight.
The largest total amount of the (meth)acrylate having a phosphate group and the polymerizable compound is preferably not more than 50 % by weight, more preferably not more than 30 % by weight.
By setting such a range, even when the curing condition is not enough, failure(bleed out) caused by bleeding owing to heat transfer of the uncuring is prevented from occurring.

(Polymerization initiator)

In the case where the outermost organic layer is formed by curing a polymerizable composition comprising polymerizable compounds, the polymerizable composition in the invention may include a polymerization initiator. In the case where a photopolymerization initiator is used, its amount is preferably at least 0.1 mol% of the total amount of the polymerizing compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46), etc.

(Method of Formation of Outermost Organic Layer)

The method for forming the outermost organic layer is not specifically defined. For example, the layer may be formed according to a solution coating method or a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD, and the like. In the invention, the polymer may be applied for coating as its solution, or a hybrid coating method along with an inorganic material, as in JP-A 2000-323273 and 2004-25732, may also be used.
In the invention, the composition comprising the polymerizable monomer is cured by irradiation. The light for irradiation is generally a UV ray from a high-pressure mercury lamp or low-pressure mercury lamp. The radiation energy is preferably at least 0.1 J/$cm^2$, more preferably at least 0.5 J/$cm^2$. (Meth)acrylate series compounds may suffer from interference in polymerization owing to oxygen in air, and therefore, in their polymerization, the oxygen concentration or the oxygen partial pressure is preferably lowered. In the case where the oxygen concentration in polymerization is lowered according to a nitrogen purging method, the oxygen concentration is preferably not more than 2%, more preferably not more than 0.5%. In the case where the oxygen partial pressure in polymerization is lowered by a pressure reduction method, the whole pressure is preferably not more than 1000 Pa, more preferably not more than 100 Pa. Especially preferred is UV polymerization with at least 0.5 J/$cm^2$ energy radiation under a condition of reduced pressure of not more than 100 Pa.
Preferably, the rate of polymerization of monomer composing the outermost organic layer is at least 85%, more preferably at least 88%, even more preferably at least 90%, still more preferably at least 92%. The rate of polymerization as referred to herein means the ratio of the reacted polymerizable group to all the polymerizing group (acryloyl group and methacryloyl group) in the monomer mixture. The rate of polymerization may be quantitatively determined according to IR absorptiometry.
The mean roughness (Ra) in 1 $\mu$m square of the outermost organic layer is preferably not more than 1 nm, more preferably not more than 0.5 nm. The surface of the outermost organic layer is required not to have impurities and projections such as particles. Accordingly, it is desirable that the organic layer is formed in a clean room. The degree of cleanness is preferably not more than class 10000, more preferably not more than class 1000.
The hardness of the outermost organic layer is preferably higher. It is recognized that, when the hardness of the outermost organic layer is high, an inorganic layer having a more smooth surface can be formed, and as a result, the barrier property is enhanced. The hardness of the outermost organic layer is preferably 0.02 to 0.5 GPa, more preferably 0.03 to 0.5 GPa, further more preferably 0.03 to 0.3 GPa. By setting the hardness to such a range, the flexibility is enhanced and the damage resistance is improved up to a level not having practical problems.

(First Organic Layer and Second Organic Layer)

The above first organic layer is not specifically limited for its composition, production method, and other various conditions without diverting the scope of the invention, and preferably is the same as for those in the outermost organic layer except for the layer thickness. By using common composition for both layers, the production process becomes

easier. For example, when the first organic layer and the outermost organic layer are formed by coating, use of the common composition can easily produce the gas barrier film by only changing the amount to be coated. That is, those layers satisfies the following formula;

$$a'/b' \geqq 2$$

wherein a' stands for a coating thickness of the outermost organic layer and b' stands for a coating thickness of the first organic layer.

Furthermore, in the case of laminating a second organic layer, a third organic layer and the like, those layers preferably formed according to a similar process.

(Inorganic Layer)

The inorganic layer is, in general, a layer of a thin film formed of a metal compound. For forming the inorganic layer, employable is any method capable of producing the intended thin film. For it, for example, suitable are physical vapor deposition methods (PVD) such as vapor evaporation method, sputtering method, ion plating method; various chemical vapor deposition methods (CVD) ; liquid phase growth methods such as plating or sol-gel method. Not specifically defined, the component to be in the inorganic layer may be any one satisfies the above-mentioned requirements. For example, it includes metal oxides, metal nitrides, metal carbides, metal oxide-nitrides, or metal oxide-carbides. Preferably used are oxides, nitrides, carbides, oxide-nitrides, or oxide-carbides comprising at least one metal selected from Si, Al, In, Sn, Zn, Ti, Cu, Ce and Ta. Of those, preferred are oxides, nitrides, carbides, oxide-nitrides, or oxide-carbides of a metal selected from Si, Al, In, Sn, Zn and Ti; more preferred are oxides, nitrides or oxide-nitrides with Si or Al. These may contain any other element as a subsidiary component.

Preferably, the surface smoothness of the inorganic layer formed in the invention is less than 1 nm in terms of the mean roughness (Ra value) in 1 μm square, more preferably not more than 0.5 nm. Accordingly, it is desirable that the inorganic layer is formed in a clean room. Preferably, the degree of cleanness is not more than class 10000, more preferably not more than class 1000.

Not specifically defined, the thickness of the inorganic layer is generally within a range of from 5 to 500 nm/layer, preferably from 10 to 200 nm/layer.

(Lamination of Organic Layer and Inorganic Layer)

The organic layer and the inorganic layer may be laminated by repeated film formation to form the organic layer and the inorganic layer in a desired layer constitution. In case where the inorganic layer is formed according to a vacuum film formation method such as sputtering method, vacuum evaporation method, ion plating method or plasma CVD method, then it is desirable that the organic layer is also formed according to a vacuum film formation method such as the above-mentioned flash vapor deposition method.

While the barrier layer is formed, it is especially desirable that the organic layer and the inorganic layer are laminated all the time in a vacuum of not more than 1000 Pa, not restoring the pressure to an atmospheric pressure during the film formation. More preferably, the pressure is not more than 100 Pa, even more preferably not more than 50 Pa, still more preferably not more than 20 Pa.

Numbers of the organic layers and the inorganic layer are not specifically limited, however, it is generally 3 to 30.

(Functional Layer)

The gas barrier film of the invention may have a functional layer on the gas barrier film or in any other position. The functional layer is described in detail in JP-A 2006-289627, paragraphs 0036 to 0038. Examples of other functional layers than those are a matting agent layer, a protective layer, a solvent-resistant layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, etc.

(Substrate Film)

The gas barrier film of the invention generally uses a plastic film as a substrate film. Preferable substrate films are those disclosed in JP-A-2009-172993, paragraph 0009 to 0012.

<Device>

The gas barrier film of the invention is preferably used for a device of which performance is deteriorated by chemical components in the air such as oxygen, water, oxide nitride, sulfur oxides, and ozone. Examples of the above device include an organic EL device, a liquid crystal device, a thin-film transistor, a touch panel, an electronic paper and a solar cell, and the device is preferably an organic device. The gas barrier film of the invention can be used for a substrate of a device or a film for sealing by a solid sealing method. Such a solid sealing method is that forming a protective layer on the device, and then, stacking an adhesive layer and a gas barrier film and curing those layers. The adhesive is not specifically limited, and is exemplified by a thermosetting epoxy resin, photo-curable acrylate resin, and the like.

(Organic EL Device)

Examples of an organic EL device with a gas barrier film are described in detail in JP-A 2007-30387.

(Liquid Crystal Device)

Examples of a liquid crystal device with a gas barrier film are described in detail in JP-A-2009-172993, paragraph 0044.

(Solar Cell)

The gas barrier film of the invention can be used also as a sealing film for solar cell devices. Preferably, the gas barrier film of the invention is used for sealing a solar cell device in such a manner that its adhesive layer is on the side near to the solar cell device. The solar cell devices for which the gas barrier film of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

(Electronic paper)

The multiple-film of the invention can be used in an electronic paper. The electronic paper is a reflection-type electronic display capable of attaining a high precision and a high contrast.

The electronic paper has a display media and a TFT driving the display media on a substrate. Any known display media can be used in the electronic paper. For example, any display media of electophoretic-type, electopowder flight-type, charged tonner-type, electrochromic type can be preferably used. Among them, electophoretic display media is more preferable and microcapsule-type electophoretic display media is particularly preferable. The electophoretic display media has a plural number of capsules and each capsule has at least one particle capable of moving in a suspension flow. The at least one particle is preferably an electrophoretic particle or a spinning ball. The electrophretic display media has a first plane and a second plane that are placed in parallel, and an image is displayed through one of the two planes.

A TFT formed on a substrate comprises a gate electrode, gate insulating layer, an active layer, a source electrode and a drain electrode. A TFT also comprises a resistance layer between the active layer and the source electrode and/or between the active layer and the drain electrode to attain electric connection.

When a color display with a high precision is produced, TFT's are preferably formed on a color filter to precisely align them. Normal TFT with a low electric efficiency can not be down-sized much while obtaining the necessary driving current, and when a high precision display is pursued, the rate of the area for the TFT in a pixel must be high. When the rate of the area for the TFT is high, the rate of the opening area and contrast are low. Even when a transparent amorphous IGZO-type TFT is used, light transmittance is not 100% and reduction of contrast is unavoidable. Use of the TFT disclosed in JP-A 2009-21554 and the like can reduce the rate of the TFT in a pixel and improve the rate of the opening area and contrast. High precision can also be attained by forming this type of TFT on a color filter directly.

(Others)

Other applications of the invention are thin-film transistors as in JP-T H10-512104, touch panels as in JP-A 5-127822, 2002-48913.

(Optical Member)

Optical member can be referred to as the description in JP-A-2009-172993, paragraph 0046.

EXAMPLES

The characteristics of the invention are described more concretely with reference to the following Examples. In the following Examples, the material used, its amount and the ratio, the details of the treatment and the treatment process may be suitably modified or changed not overstepping the sprit and the scope of the invention. Accordingly, the invention should not be limitatively interpreted by the Examples mentioned below.

(Example1)

1. Formation of Gas Barrier Film

A polyethylene naphthalate film with an easy adhesive layer (manufactured by Teijin DuPont Films Japan Limited, Teonex® Q65FA) was cut into 20 cm square. On the easy adhesive layer, an organic layer and an inorganic layer were formed by the following method.

(1-1) Formation of Second Organic Layer

On the PET film, a polymerizable composition consisting of a polymerizable acrylate (manufacture by Daicel-Cytec Company Ltd, EBECRYL3702, 9g), a phosphate methacrylate (manufactured by Nippon Kayaku Co., Ltd., KAYAMER PM-21, 1 g), 0.6 g of an ultraviolet polymerization initiator (manufactured by Chiba Specialty. Chemicals Inc., Irgacure 907), and 190 g of 2-butanone was coated using a wire bar, and was cured through irradiation with UV rays from a high-pressure mercury lamp (the total dose is 1 J/cm$^2$) in a chamber which was controlled to be oxygen concentration of 0.1 % or less by nitrogen substitution, thereby producing the organic layer having a thickness of 333 μm.

(1-2) Formation of Inorganic Layer

Using a sputtering device, an inorganic layer (aluminium oxide layer) was formed on the second organic layer. Aluminium as target, argon as flow gas, and oxygen as reactive gas were used. The formation pressure was 0.1 Pa, and the attained film thickness was 50 nm. Thus, the inorganic layer was laminated on the second organic layer.

(1-3) Formation of First Organic Layer

The first organic layer was formed according to the same method as that in the above (1-1).

(1-4)Formation of Inorganic Layer

The inorganic layer was formed according to the same method as that in the above (1-2).

(1-5) Formation of Outermost Organic Layer

The outermost organic layer was formed according to the same method as that in the above (1-1), except that the thickness of the outermost organic layer is 1.0 μm. Thereby, a gas barrier film No.1 was obtained.

<Measurement of Hardness>

Hardness of the outermost organic layer of the obtained gas barrier film was measured according to the method disclosed in JP-A-2004-354842.

<Measurement of Water Vapor Permeability by MOCON (Barrier Property)>

The waver vapor permeability of the obtained gas barrier film was evaluated using PERMATRAN-W3/31 manufactured by MOCON at 40°C for Relative Humidity (RH) of 90%. The detection limit value according to this measuring method is 0.005 g/m$^2$/day.

<Test for Adhesiveness>

In order to evaluate the adhesiveness of the gas barrier film, cross-cut adhesiveness test compliant to JIS K5400 was carried out. The surface of the gas barrier films having the above construction was cut in at the entering angle of 90 degree toward the film surface at 1 mm interval using a cutter, thereby producing one hundred of cross-cut at 1 mm interval. On the surface thereof, Mylar tape having the wide of 2 cm (manufactured by Nitto Denko, polyester tape, No. 31B) was attached, and then was peeled off using a tape peeling testing machine. The number (n) of the remaining grids which didn't peel off from one hundred of cross-cut on the laminated film was counted.

○:not less than 70
Δ:not less than 50 to less than 70
×: less than 50

<Test for Flexibility>

The flexibility was evaluated according to a cylindrical mandrel method (JIS K5600-5-1), wherein the film was set so that the film-formation side of each sample was outside. After the test, crack was observed with a light microscope, and the maximum diameter (mm) in which the crack was not observed was defined as the flexibility value.

<Damage Resistance >

Using scratching intensity tester (manufactured by SHINTO Scientific C., Ltd) with 0.05 mmR of sapphire needle, the test for the surface of the film-formation side of the sample was carried out. Loading at the time that the surface started being injured was measured and the loading was defined as scratching intensity (g).

○: not less than 25 g
Δ: not less than 20 g to less than 25 g
×: less than 20 g

<Discarded Dimension >

A sample was cut with cutter, and then the cut portion was observed with a light microscope, to thereby measure length of crack from the edge.

Each of gas barrier films of Examples and Comparative Examples (Com. Example) was formed according to the same method as that in the gas barrier film No.1, except that the thickness of the outermost organic layer (unit: μm), the ratio (a/b) between the thickness of the outermost organic layer (a) and the thickness of the first organic layer (b), the phosphate (added or not added), and the easy adhesive layer (provided or not provided) were changed to those shown in the following table.

[Table 1]

| | | Thickness of Outermost Organic Layer | Thickness Ratio | Hardness of Outermost Organic Layer (GPa) | Phosphate Monomer | Easy Adhesive Layer | Barrier Property ($g/m^2/day$) | Adhesiveness | Flexibility (mm) | Damage Resistance | Discarded Dimension (mm) |
|---|---|---|---|---|---|---|---|---|---|---|---|
| No. 1 | Example | 1.0 | 3 | 0.2 | Added | Provided | 0.005 or less | ○ | 7 | ○ | 1 |
| No. 2 | Example | 1.0 | 2 | 0.2 | Added | Provided | 0.005 or less | ○ | 8 | ○ | 3 |
| No. 3 | Com. Exam. | 1.0 | 1 | 0.2 | Added | Provided | 0.005 or less | ○ | 12 | ○ | 8 |
| No. 4 | Com. Exam. | 1.0 | 0.5 | 0.2 | Added | Provided | 0.005 or less | ○ | 13 | ○ | 8 |
| No. 5 | Example | 0.4 | 3 | 0.2 | Added | Provided | 0.005 or less | ○ | 8 | ○ | 4 |
| No. 6 | Example | 0.4 | 2 | 0.2 | Added | Provided | 0.005 or less | ○ | 9 | ○ | 5 |
| No. 7 | Com. Exam. | 0.4 | 1 | 0.2 | Added | Provided | 0.005 or less | ○ | 13 | ○ | 9 |
| No. 8 | Com. Exam. | 0.4 | 0.5 | 0.2 | Added | Provided | 0.005 or less | ○ | 13 | ○ | 9 |
| No. 9 | Example | 1.0 | 3 | 0.02 | Added | Provided | 0.005 or less | ○ | 7 | Δ | 1 |
| No. 10 | Example | 1.0 | 3 | 0.03 | Added | Provided | 0.005 or less | ○ | 7 | ○ | 1 |
| No. 11 | Example | 1.0 | 3 | 0.5 | Added | Provided | 0.005 or less | ○ | 10 | ○ | 5 |
| No. 12 | Example | 1.0 | 3 | 0.2 | Not added | Provided | 0.005 or less | Δ | 7 | ○ | 1 |
| No. 13 | Example | 1.0 | 3 | 0.2 | Added | Not Provided | 0.005 or less | Δ | 7 | ○ | 1 |

(continued)

| | | Thickness of Outermost Organic Layer | Thickness Ratio | Hardness of Outermost Organic Layer (GPa) | Phosphate Monomer | Easy Adhesive Layer | Barrier Property (g/$m^2$/day) | Adhesiveness | Flexibility (mm) | Damage Resistance | Discarded Dimension (mm) |
|---|---|---|---|---|---|---|---|---|---|---|---|
| No. 14 | Example | 0.4 | 2 | 0.02 | Added | Provided | 0.005 or less | ○ | 9 | Δ | 4 |
| No. 15 | Com. Exam. | 0.2 | 2 | 0.2 | Added | Provided | 0.005 or less | ○ | 11 | × | - |
| No. 16 | Com. Exam. | 0.2 | 1 | 0.2 | Added | Provided | 0.005 or less | ○ | 13 | × | - |
| No. 17 | Com. Exam. | 0.2 | 0.5 | 0.2 | Added | Provided | 0.005 or less | ○ | 14 | × | - |
| No. 18 | Com. Exam. | - | - | - | - | Provided | 0.005 or less | ○ | 14 | × | - |

It was found that the gas barrier films of the invention are excellent in barrier property and flexibility, compared with the gas barrier films of the comparative examples from the above table.

A gas barrier film was formed according to the same method as that in the gas barrier film No.1, except that the hardness of the outermost organic layer was 0.6 GPa. The gas barrier film was evaluated according to that for the gas barrier film No. 1. It was confirmed that the gas barrier films No.1, No.10 and No.11 were more excellent in adhesiveness, compared with the obtained gas barrier film.

2. Formation and Evaluation of Organic EL Device

(2-1) Formation of Organic EL Device

An ITO film-having conductive glass substrate (surface resistivity, 10 Q/square) was washed with 2-propanol, and then processed for UV ozone treatment for 10 minutes. On the substrate (anode), the following compound layers were formed in order by vapor deposition according to a vacuum vapor deposition method.

(First Hole Transporting Layer)

Copper phthalocyanine: film thickness 10 nm.

(Second Hole Transporting Layer)

N,N'-diphenyl-N,N'-dinaphthylbenzidine: film thickness 40 nm.

(Light-Emitting Layer also serving as electron transporting layer)

Tris(8-hydroxyquinolinato)aluminium: film thickness 60 nm.

On the surface thereof, lithium fluoride having a film thickness of 1 nm and metal aluminium having a thickness 100 nm were deposited in that order to thereby form cathode. Then, on the surface thereof, a silicon nitride film having a thickness of 5μm was formed by a parallel plate CVD method to thereby form an organic EL device.

(2-2) Installation of Gas Barrier Film to Organic EL Device

Using a thermosetting adhesive (Epotec 310, by Daizo-Nichimori), the gas-barrier film of Samples No. 1 and the organic EL device substrate were stuck together in such a manner that the barrier layer of the film is on the side of the organic EL device, and heated at 65°C for 3 hours to cure the adhesive. 20 test pieces of every sample of the thus-sealed organic EL device were prepared.

(2-3)Evaluation of Light-emitting Surface of Organic EL Device

Just after produced, the organic EL device was tested for light emission under application of 7 V thereto, using a source measure unit (SMU2400 Model by Keithley). Using a microscope, the light-emitting surface was observed, which confirmed uniform light emission by every device with no dark spot.

Finally, the devices were stored in a dark room at 60°C and 90% RH for 500 hours, and then tested for light emission. The proportion of the test pieces that gave dark spots larger than 300 μm in diameter is defined as a failure rate. The failure rate of every sample was computed. The failure rate was 1% or less.

Industrial applicability

In general, there is a problem in that damage is caused on the surface of the gas barrier film for use in an organic EL device and the like in the process of forming a panel. In the invention, the thickness of the outermost organic layer is adjusted to a particular thickness, so that the scratching in one of the preferred embodiments is effectively reduced.

In particular, handability of the gas barrier film in the case of producing an organic EL device and the like using the gas barrier film of the invention is enhanced. This is because the gas barrier film of the invention is excellent in flexibility, so that the discarded dimension in cutting is made to be 5 mm or less, and the gas barrier film is less damaged. In addition, since the gas barrier film of the invention is not limited for materials composing the organic layer and the inorganic layer, the adaptable range thereof is advantageously wide.

Adhesiveness between layers of the gas barrier film is also an important parameter. In one preferred embodiment of the invention, it is possible to enhance the adhesiveness by using a (meth)acrylate comprising a phosphoester group.

In the invention, the outermost organic layer may use the same composition as that of the other organic layers. Thereby, it is possible to enhance the productivity of the gas barrier film.

In the invention, burr at the edge of the gas barrier film is reduced. Thereby, it is possible to prevent contamination in processing.

## Claims

1. A gas barrier film comprising a substrate film (1), a first organic layer (2), an inorganic layer (3) and an outermost organic layer (4) in that order,
wherein the outermost organic layer has a thickness of 0.3 μm or more; and
which satisfies the following formula;

$$a/b \geq 2,$$

wherein a represents the thickness of the outermost organic layer, b represents the thickness of the first organic layer, and wherein the outermost organic layer has a thickness of 0.3 to 10 μm.

2. The gas barrier film according to Claim 1, wherein the first organic layer and the inorganic layer are adjacent to each other; and the inorganic layer and the outermost organic layer are adjacent to each other.

3. The gas barrier film according to Claim 1 or 2, wherein the first organic layer has the same composition as the outermost organic layer.

4. The gas barrier film according to any one of Claims 1 to 3, wherein the first organic layer and the outermost organic layer each are obtained by curing a polymerizable composition comprising a (meth)acrylate monomer having a phosphoester group.

5. The gas barrier film according to any one of Claims 1 to 4, which has two or more inorganic layers.

6. The gas barrier film according to any one of Claims 1 to 5, which has an easy adhesive layer on the outermost organic layer.

7. The gas barrier film according to any one of Claims 1 to 6, which satisfies $a/b \geq 3$.

8. The gas barrier film according to any one of Claims 1 to 7, wherein the inorganic layer has a thickness of 5 to 500 nm.

9. The gas barrier film according to any one of Claims 1 to 8, wherein the inorganic layer comprises oxides, nitrides, carbides, oxide-nitrides, or oxide-carbides comprising at least one metal selected from Si, Al, In, Sn, Zn, Ti, Cu, Ce and Ta.

10. A device comprising the gas barrier film of any one of Claims 1 to 9.

11. The device according to Claim 10, wherein the device is an organic EL device.

## Patentansprüche

1. Gassperrfilm, enthaltend einen Substratfilm (1), eine erste organische Schicht (2), eine anorganische Schicht (3) und eine äußerste organische Schicht (4) in dieser Reihenfolge,
worin die äußerste organische Schicht eine Dicke von 0,3 μm oder mehr hat und
die die folgende Formel erfüllt;

$$a/b \geq 2$$

worin a die Dicke der äußersten organischen Schicht ist, b die Dicke der ersten organischen Schicht ist und worin die äußerste organische Schicht eine Dicke von 0,3 bis 10 μm hat.

2. Gassperrfilm gemäß Anspruch 1, worin die erste organische Schicht und die anorganische Schicht nebeneinander angeordnet sind; und die anorganische Schicht und die äußerste organische Schicht nebeneinander angeordnet sind.

3. Gassperrfilm gemäß Anspruch 1 oder 2, worin die erste organische Schicht die gleiche Zusammensetzung wie die äußerste organische Schicht hat.

4. Gassperrfilm gemäß einem der Ansprüche 1 bis 3, worin die erste organische Schicht und die äußerste organische Schicht jeweils erhalten sind durch Härten einer polymerisierbaren Zusammensetzung, enthaltend ein (Meth)acrylatmonomer mit einer Phosphoestergruppe.

5. Gassperrfilm gemäß einem der Ansprüche 1 bis 4, die zwei oder mehrere anorganische Schichten hat.

6. Gassperrfilm gemäß einem der Ansprüche 1 bis 5, die eine leichte Adhäsiveschicht auf der äußersten organischen Schicht hat.

7. Gassperrfilm gemäß einem der Ansprüche 1 bis 6, der erfüllt $a/b \geq 3$.

8. Gassperrfilm gemäß einem der Ansprüche 1 bis 7, worin die anorganische Schicht eine Dicke von 5 bis 500 nm hat.

9. Gassperrfilm gemäß einem der Ansprüche 1 bis 8, worin die anorganische Schicht Oxide, Nitride, Carbide, Oxid-Nitride oder Oxid-Carbide enthält, die zumindest ein Metall enthalten, ausgewählt aus Si, Al, In, Sn, Zn, Ti, Cu, Ce und Ta.

10. Vorrichtung, enthaltend den Gassperrfilm gemäß einem der Ansprüche 1 bis 9.

11. Vorrichtung gemäß Anspruch 10, worin die Vorrichtung eine organische EL-Vorrichtung ist.

**Revendications**

1. Film barrière contre les gaz comprenant un film (1) faisant office de substrat, une première couche organique (2), une couche inorganique (3) et une couche organique la plus externe (4), dans cet ordre ;
dans lequel la couche organique la plus externe possède une épaisseur de 0,3 μm ou plus ; et
qui répond à la formule suivante :

$$a/b \geq 2\ ;$$

dans laquelle a représente l'épaisseur de la couche organique la plus externe, b représente l'épaisseur de la première couche organique, et dans lequel la couche organique la plus externe possède une épaisseur de 0,3 à 10 μm.

2. Film barrière contre les gaz selon la revendication 1, dans lequel la première couche organique et la couche inorganique sont adjacentes l'une à l'autre ; et la couche inorganique et la couche organique la plus externe sont adjacentes l'une à l'autre.

3. Film barrière contre les gaz selon la revendication 1 ou 2, dans lequel la première couche organique possède la même composition que celle de la couche organique la plus externe.

4. Film barrière contre les gaz selon l'une quelconque des revendications 1 à 3, dans lequel la première couche organique et la couche organique la plus externe sont obtenues par durcissement d'une composition polymérisable comprenant un monomère de (méth)acrylate possédant un groupe phosphoester.

5. Film barrière contre les gaz selon l'une quelconque des revendications 1 à 4, qui possède deux couches inorganiques

ou plus.

6. Film barrière contre les gaz selon l'une quelconque des revendications 1 à 5, qui possède une couche aisément adhésive sur la couche organique la plus externe.

7. Film barrière contre les gaz selon l'une quelconque des revendications 1 à 6, qui répond à la formule $a/b \geq 3$.

8. Film barrière contre les gaz selon l'une quelconque des revendications 1 à 7, dans lequel la couche inorganique possède une épaisseur de 5 à 500 nm.

9. Film barrière contre les gaz selon l'une quelconque des revendications 1 à 8, dans lequel la couche inorganique comprend des oxydes, des nitrures, des carbures, des nitrures d'oxydes ou des carbures d'oxydes comprenant au moins un métal choisi parmi Si, Al, In, Sn, Zn, Ti, Cu, Ce et Ta.

10. Dispositif comprenant le film barrière contre les gaz selon l'une quelconque des revendications 1 à 9.

11. Dispositif selon la revendication 10, dans lequel le dispositif est un dispositif électroluminescent organique.

Fig. 1

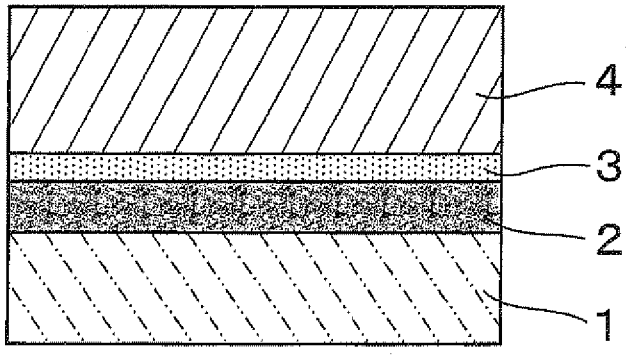


Fig. 2

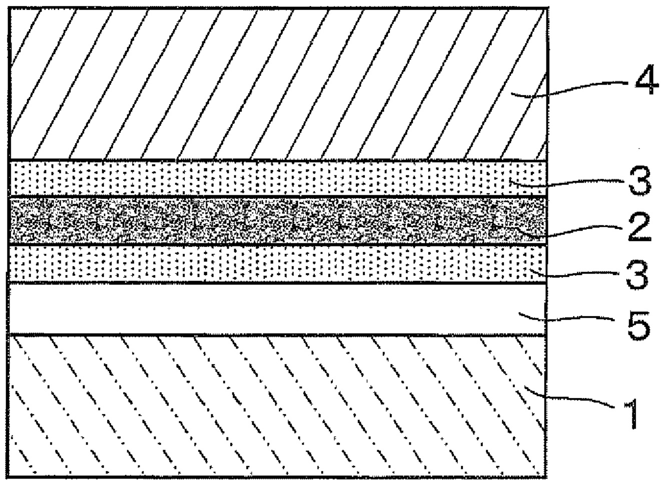

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006068967 A
- JP 2007290369 A
- US 2681294 A
- JP 2000323273 A
- JP 2004025732 A
- JP 2006289627 A
- JP 2009172993 A
- JP 2007030387 A
- JP 2009021554 A
- JP TH10512104 B
- JP 5127822 A
- JP 2002048913 A
- JP 2004354842 A